(19) Europäisches Patentamt / European Patent Office / Office européen des brevets

(11) **EP 2 582 048 B1**

(12) **FASCICULE DE BREVET EUROPEEN**

(45) Date de publication et mention de la délivrance du brevet:
**10.04.2019 Bulletin 2019/15**

(51) Int Cl.:
***H03K 19/177*** *(2006.01)*

(21) Numéro de dépôt: **12188039.7**

(22) Date de dépôt: **10.10.2012**

(54) **Système d'au moins un ensemble comprenant au moins un circuit intégré, lesdits circuits intégrés étant interconnectés selon une architecture matricielle, muni d'au moins une interconnexion optique**

System, das mindestens aus einer Anordung mit mindestens einem integrierten Schaltkreis besteht, bei dem diese integrierten Schaltkreise in Form einer Matrixarchitektur miteinander verbunden sind, und das mit mindestens einer optischen Verbindung ausgestattet ist

System with at least one assembly including at least one integrated circuit, said integrated circuits being interconnected according to a matrix architecture, provided with at least one optical interconnection

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **14.10.2011 FR 1103141**

(43) Date de publication de la demande:
**17.04.2013 Bulletin 2013/16**

(73) Titulaire: **Thales**
**92400 Courbevoie (FR)**

(72) Inventeurs:
• **Oster, Yann**
**31270 FROUZIN (FR)**
• **Sotom, Michel**
**31400 TOULOUSE (FR)**
• **Venet, Norbert**
**31880 LA SALVETAT SAINT GILLES (FR)**

(74) Mandataire: **Brunelli, Gérald**
**Marks & Clerk France**
**Immeuble Visium**
**22, avenue Aristide Briand**
**94117 Arcueil Cedex (FR)**

(56) Documents cités:
**EP-A1- 1 569 495      US-A- 5 278 548**
**US-A1- 2004 249 964      US-A1- 2007 101 242**

EP 2 582 048 B1

## Description

La présente invention porte sur un système d'au moins un ensemble comprenant au moins un circuit intégré, lesdits circuits intégrés étant interconnectés selon une architecture matricielle de N lignes et M colonnes de circuits intégrés.

Il est connu des systèmes d'au moins un ensemble d'au moins un circuit intégré, lesdits circuits intégrés étant interconnectés selon une architecture matricielle de circuits intégrés, dans lesquels les circuits intégrés sont reliés entre-eux par des connexions électriques, dont certaines de type interfaces série rapides à haut débit, de fréquence largement supérieure à 100 MHz.

On entend par circuit intégré, un composant électronique réalisant une fonction électronique plus ou moins complexe, et intégrant souvent plusieurs types de composants électroniques élémentaires dans un boîtier de volume réduit. Les portes logiques sont les circuits intégrés numériques les plus simples, les microprocesseurs et les mémoires figurent parmi les plus complexes. On trouve des circuits intégrés dédiés à des applications spécifiques tels des circuits intégrés d'application spécifique ou ASIC pour "Application Specific Integrated Circuit" en langue anglaise, notamment pour du traitement de signal ; on parle alors de processeur de signal numérique ou DSP pour "Digital Signal Processor" en langue anglaise. Une famille importante de circuits intégrés est celle des composants de logique programmable ou FPGA pour "Field Programmable Gâte Array" en langue anglaise.

On entend par module hybride, un composant intégrant dans un même boîtier un ensemble de circuits interconnectés, réalisés éventuellement dans différentes technologies, et pouvant traiter des signaux de différentes natures (analogiques, radio-fréquence, numériques, optiques).

Les traitements sont morcelés sur une pluralité d'opérateurs, qui peuvent être des circuits intégrés, des circuits ou modules hybrides, qui sont assemblés sur des cartes électroniques au sein d'équipements. Dans ce qui suit, on utilise le terme circuit intégré également pour des modules hybrides.

Dans ce qui suit, l'organisation en lignes ou en colonnes résulte d'un choix arbitraire, le rôle des lignes et des colonnes pouvant être librement permuté.

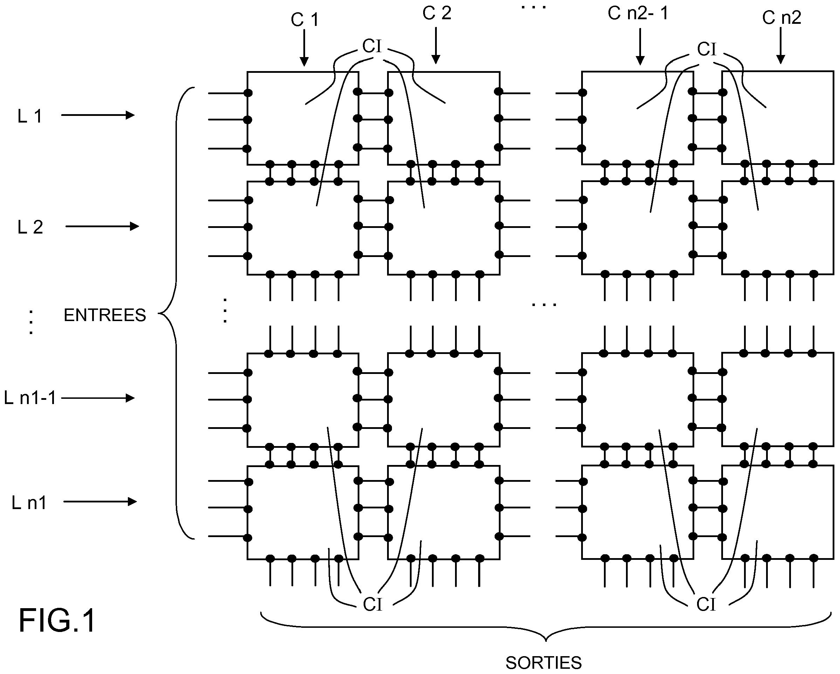

Considérant des traitements réalisés sur un ensemble de circuits organisé en colonne, les entrées sources primaires d'une ligne du système sont transmises à l'ensemble des colonnes, donc à l'ensemble des circuits intégrés de la même ligne. Avec des interfaces électriques de type série rapide point à point, une technique connue consiste à propager les données sources de proche en proche sur une même ligne, un circuit intégré transmet les données reçues sur ses entrées sources au circuit intégré suivant de la même ligne, et réalise des traitements dont les résultats sont transmis au circuit suivant de la même colonne. La figure 1 illustre un tel exemple, dans lequel le système comprend des ensembles d'au moins un circuit intégré CI, lesdits circuits intégrés étant interconnectés selon une architecture matricielle de n1 lignes Li et n2 colonnes Cj de circuits intégrés CI, en l'espèce identiques. Le système représenté comprend 3n1 entrées ou voies de données et 4n2 sorties, car, en l'occurrence les circuits intégrés CI ont chacun 3 entrées et 4 sorties ou voies de traitement.

L'intérêt principal d'un tel système réside dans sa simplicité fonctionnelle et sa modularité. En particulier, les nombres d'entrées et de sorties du système peuvent être ajustés par ajout de lignes ou de colonnes. Par contre, pour des besoins complexes, ce type de système fait appel à un grand nombre de circuits intégrés et de cartes électroniques, et un grand nombre d'interconnexions et d'interfaces. Ce type de système consomme beaucoup d'énergie, et nécessite une surface et une masse importantes, dont une grande part est due aux interfaces elles-mêmes.

La demande de brevet américain US 2005/0256969 A1 porte sur l'interconnexion électrique de circuits numériques avec des liens série rapide, en intégrant un commutateur de paquets au sein de chaque circuit. Ainsi, il divulgue une architecture reconfigurable à base de réseaux de portes programmables ou FPGA.

Le document US 4811210 vise à mettre en oeuvre différentes fonctions et différents types d'algorithmes, sur un même ordinateur en utilisant une architecture reconfigurable et parallèle. La solution proposée comprend des groupes de processeurs intégrant respectivement un commutateur optique pour configurer et modifier les interconnexions au sein du groupe et des commutateurs optiques d'échanges entre les groupes.

Ce mode d'organisation matérielle ne convient pas bien à une architecture matricielle en logique câblée spécifique pour une application, et ne permet notamment pas d'en réduire la complexité et la consommation énergétique.

Le document US 4696059 vise à implanter des fonctions de traitement du signal rapide (filtre programmable, générateur de mot, ligne à retard programmable), alors que les fonctions élémentaires de retard sont soit insuffisamment rapides, soit non ajustables. La solution proposée comprend un commutateur optoélectronique et des groupes de fonctions à retard, soit électriques soit optiques. Les éléments, en technologie optique, permettent de réaliser le besoin de rapidité de la fonction de retard élémentaire. Le commutateur permet de configurer dynamiquement la connectivité entre les entrées primaires et les entrées/sorties des fonctions retard, afin de synthétiser différentes valeurs de retard, de construire des filtres ou des générateurs de mots.

Cette architecture ne permet pas de construire un système matriciel complexe comportant un grand nombre d'opérateurs et de circuits intégrés et réalisant des traitements complexes.

Un but de l'invention est de pallier les problèmes précédemment cités.

Il est proposé, selon un aspect de l'invention, un système d'au moins un ensemble d'au moins un circuit intégré, lesdits circuits intégrés étant interconnectés selon une architecture matricielle de N lignes et M colonnes de circuits intégrés. Une ligne reçoit au moins une entrée de signaux, et une colonne fournit au moins une sortie de signaux. Les interconnexions entre deux circuits intégrés d'une ligne d'un même ensemble et les interconnexions entre deux circuits intégrés d'une colonne d'un même ensemble sont électriques. Un ensemble d'au moins un circuit intégré comprend au moins un circuit intégré d'entrée comprenant au moins une entrée dudit ensemble et au moins un circuit intégré de sortie comprenant au moins une sortie dudit ensemble, un circuit intégré d'entrée pouvant éventuellement être un circuit intégré de sortie. En outre, le système comprend au moins une interconnexion optique pour connecter une entrée d'une ligne du système à une entrée respective des circuits intégrés d'entrée des ensembles appartenant à ladite ligne, ou pour connecter une sortie respective des circuits intégrés de sortie des ensembles appartenant à une colonne du système à la sortie système de ladite colonne.

Un tel système permet de réduire de manière conséquente le besoin en interfaces série rapides au sein des circuits intégrés, et par voie de conséquence la consommation d'énergie et la complexité d'implantation, en terme de quantité de circuits et de cartes électroniques. Avec un besoin réduit jusqu'à moitié en nombre d'interfaces série rapides dans les circuits intégrés, ce système permet une meilleure utilisation des ressources et des ports d'entrées et de sorties des circuits intégrés, et réduit la complexité de l'équipement.

L'utilisation de liens optiques permet généralement d'augmenter la bande passante, et de réduire de façon drastique la masse et l'encombrement des liaisons et des connecteurs.

Dans un mode de réalisation, un ensemble d'au moins un circuit intégré est implanté dans une unique carte électronique.

Ainsi, la réalisation d'un tel système peut être faite à partir d'une pluralité d'exemplaires d'une même carte, ce qui facilite la réalisation du système et baisse son coût de réalisation.

Selon un mode de réalisation, une interconnexion optique comprend un coupleur optique et/ou des moyens de couplage optoélectroniques actifs et un lien optique par entrée de circuit intégré d'entrée des ensembles d'une ligne ou par sortie de circuit intégré de sortie des ensembles d'une colonne.

Ainsi, les liaisons optiques permettent de réaliser simplement la diffusion des signaux à haut débit d'un point à une pluralités de points, et/ou de combiner un ensemble de sorties en provenance de plusieurs circuits intégrés, sans affecter significativement le débit et la qualité des signaux aux interfaces.

Avantageusement, au moins une interconnexion optique de ligne comprend, en outre, un lien optique de test.

Ainsi, il est possible de mettre en place des moyens de test/surveillance non intrusifs, pour observer les signaux sans perturber le fonctionnement du système, ou injecter des signaux de test dans le système.

Par exemple, un lien optique comprend de la fibre optique.

L'utilisation de fibre optique permet entre autres d'augmenter la bande passante ou la distance de transmission, de garantir une bonne isolation entre les différents liens, ou de faciliter l'implantation physique des liens.

Selon un mode de réalisation, au moins une interconnexion optique de ligne comprend, en outre, un amplificateur optique.

Ainsi, la puissance du signal optique à distribuer par les sorties d'un coupleur optique peut être adaptée au besoin de distribution, afin de garantir la performance de transmission des liaisons.

Dans un mode de réalisation, plusieurs interconnexions optiques de ligne peuvent être reliées en entrée par au moins un commutateur optique, et/ou plusieurs interconnexions optiques de colonne peuvent être reliées en sortie par au moins un commutateur optique.

Il est ainsi possible de mettre en oeuvre une gestion de redondance, notamment pour des systèmes embarqués, par exemple à bord de satellites, en configurant des commutateurs optiques, dont la dissipation est indépendante des débits traités.

Selon un mode de réalisation, au moins un lien optique est adapté pour réaliser un multiplexage par répartition en longueur d'onde.

Dans un mode de réalisation, le système comprend au moins un ensemble de circuits intégrés en redondance, muni de liens optiques.

Par exemple, le système tel que décrit précédemment peut être adapté pour réaliser une fonction de formation numérique de faisceaux d'antenne, et/ou pour réaliser une fonction de commutation.

Il est également proposé, selon un autre aspect de l'invention, un processeur comprenant au moins un système tel que précédemment décrit.

Il est également proposé, selon un autre aspect de l'invention, un satellite comprenant au moins un processeur tel que précédemment décrit embarqué à bord.

Il est également proposé, selon un autre aspect de l'invention, un procédé d'interconnexion d'au moins un ensemble d'au moins un circuit intégré, selon une architecture matricielle de n1 lignes et n2 colonnes de circuits intégrés, une ligne recevant au moins une entrée de signaux, et une colonne fournissant au moins une sortie de signaux, les interconnexions entre deux circuits intégrés d'une ligne d'un même ensemble et les interconnexions entre deux circuits intégrés d'une colonne d'un même ensemble étant réalisées électriquement, et un ensemble d'au moins un circuit intégré comprenant au moins un circuit intégré d'entrée comprenant au moins une entrée dudit ensemble et au moins un circuit intégré de sortie comprenant au moins une sortie dudit ensemble, un circuit intégré d'entrée pouvant éventuellement être un circuit intégré de sortie. En outre, on interconnecte optiquement au moins une entrée d'une ligne du système à une entrée respective des circuits intégrés d'entrée des ensembles, appartenant à ladite ligne, ou au moins une sortie d'une colonne du système à une sortie respective des circuits intégrés de sortie des ensembles, appartenant à ladite colonne.

L'invention sera mieux comprise à l'étude de quelques modes de réalisation décrits à titre d'exemples nullement limitatifs et illustrés par les dessins annexés sur lesquels :

- la figure 1 illustre schématiquement un mode de réalisation d'un système à architecture matricielle d'au moins un ensemble d'au moins un circuit intégré, lesdits circuits intégrés étant interconnectés selon une architecture matricielle, avec des liaisons point à point sans diffusion ni recombinaison directe, selon l'état de la technique, avec des liaisons point à point sans diffusion ni recombinaison directe ;
- la figure 2 illustre schématiquement un système à architecture matricielle comprenant au moins une interconnexion optique, selon un aspect de l'invention ;
- la figure 3 illustre schématiquement un système à architecture matricielle dans lequel un ensemble d'au moins un circuit intégré est compris dans une unique carte électronique selon un aspect de l'invention ;
- la figure 4 illustre schématiquement un système à architecture matricielle dans lequel un ensemble d'au moins un circuit intégré est compris dans une unique carte électronique, avec des liaisons optiques de test, selon un aspect de l'invention ;
- la figure 5 illustre schématiquement un système à architecture matricielle dans lequel les interconnexions optiques sont uniquement selon les lignes de l'architecture matricielle des circuits intégrés selon un aspect de l'invention ;
- la figure 6 illustre schématiquement un système à architecture matricielle pour un processeur de formation de faisceaux pour satellite selon un aspect de l'invention ;
- la figure 7 illustre schématiquement un système à architecture matricielle avec l'ensemble des interconnexions entre circuits intégrés qui sont de type optique, considérant que chaque ensemble de circuits comprend un seul circuit intégré selon un aspect de l'invention ;
- la figure 8 illustre schématiquement un système à architecture matricielle comprenant des amplificateurs optiques selon un aspect de l'invention ;
- la figure 9 illustre schématiquement un système à architecture matricielle comprenant des commutateurs optiques selon un aspect de l'invention ;

- la figure 10 illustre schématiquement un système à architecture matricielle comprenant un commutateur optique pour un processeur de formation de faisceaux pour satellite selon un aspect de l'invention ;
- la figure 11 illustre schématiquement un système à architecture matricielle comprenant une pluralité de commutateurs optiques en parallèle pour un processeur de formation de faisceaux pour satellite selon un aspect de l'invention ;
- la figure 12 illustre schématiquement un système à architecture matricielle comprenant des commutateurs optiques entre cartes électroniques pour gérer des redondances au niveau des cartes électroniques selon un aspect de l'invention ;
- la figure 13 illustre schématiquement un système à architecture matricielle comprenant des commutateurs optiques entre colonnes pour un processeur de formation de faisceaux pour satellite selon un aspect de l'invention ; et
- les figures 14 à 18 illustrent schématiquement une commutation des redondances mutualisées séparément par ligne (ou sous-fonction), selon un aspect de l'invention.

Sur l'ensemble des figures, les éléments ayant des références identiques sont similaires.

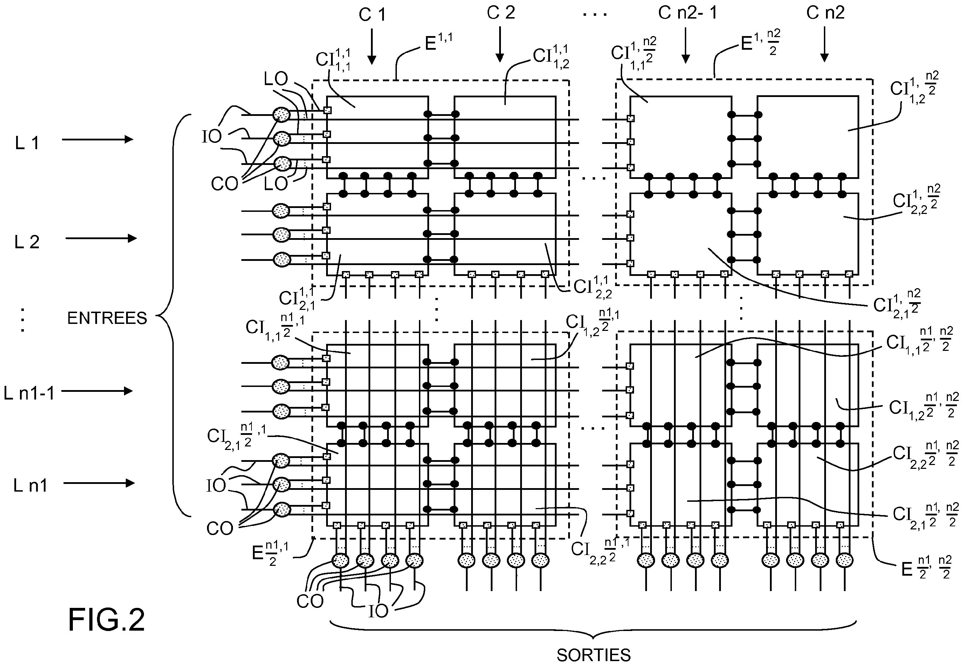

La figure 2 représente schématiquement un système d'au moins un ensemble $E^{a,b}$, en l'espèce $E^{1,1}$, ..., $E^{1,n2/2}$, ..., $E^{n1/2,1}$, ..., $E^{n1/2,n2/2}$ d'au moins un circuit intégré $CI_{i,j}^{a,b}$, en l'espèce quatre circuits intégrés $CI_{1,1}^{a,b}$, $CI_{1,2}^{a,b}$, $CI_{2,1}^{a,b}$, $CI_{2,2}^{a,b}$, (a entier variant de 1 à $\dfrac{n1}{2}$ et b entier variant de 1 à $\dfrac{n2}{2}$) lesdits circuits intégrés $CI_{i,j}^{a,b}$ (i entier variant de 1 à 2 et j entier variant de 1 à 2) étant interconnectés selon une architecture matricielle de n1 lignes et n2 colonnes de circuits intégrés $CI_{i,j}^{a,b}$. Bien sûr, cet exemple de quatre circuits intégrés par ensemble $E^{a,b}$ n'est aucunement limitatif, et les variations des indices a et b des ensembles $E^{a,b}$ dépendent du nombre de circuits intégrés par ensemble $E^{a,b}$.

Une ligne k de circuits intégrés (k entier variant de 1 à n1) reçoit au moins une entrée de signaux, en l'espèce trois entrées, et une colonne I de circuits intégrés (I entier variant de 1 à n2) fournit au moins une sortie de signaux, en l'espèce quatre sorties.

Les interconnexions entre deux circuits intégrés d'une ligne k d'un même ensemble $E^{a,b}$, lorsque cet ensemble comprend plus d'un circuit intégré par ligne, et les interconnexions entre deux circuits intégrés d'une colonne I, lorsque cet ensemble comprend plus d'un circuit intégré par colonne, sont électriques.

Un ensemble $E^{a,b}$ d'au moins un circuit intégré

$CI_{i,j}^{a,b}$ comprend au moins un circuit intégré d'entrée, i.e. recevant des signaux d'entrée de l'extérieur de l'ensemble, et au moins un circuit intégré de sortie, i.e. délivrant des signaux de sortie à l'extérieur de l'ensemble. Un circuit intégré d'entrée peut éventuellement être simultanément un circuit intégré de sortie. En l'espèce, sur l'exemple de la figure 2, pour un ensemble $E^{a,b}$, les circuits intégrés $CI_{1,1}^{a,b}$ et $CI_{2,1}^{a,b}$ sont des circuits intégrés d'entrée, et les circuits intégrés $CI_{2,1}^{a,b}$ et $CI_{2,2}^{a,b}$ sont des circuits intégrés de sortie. Le circuit $CI_{2,1}^{a,b}$ est simultanément un circuit intégré d'entrée et un circuit intégré de sortie pour l'ensemble $E^{a,b}$.

Le système comprend au moins une interconnexion optique IO, en l'occurrence 3×n1+4×n2 interconnexions optiques, pour connecter une entrée d'une ligne du système à une entrée respective des circuits intégrés d'entrée des ensembles appartenant à cette ligne (3xn1 interconnexions optiques car sur cet exemple les circuits intégrés ont tous trois entrées appartenant à des interconnexions optiques), ou pour connecter une sortie d'une colonne du système à une sortie respective des circuits intégrés de sortie des ensembles appartenant à cette colonne (4xn2 interconnexions optiques car sur cet exemple les circuits intégrés ont tous quatre sorties appartenant à des interconnexions optiques).

Les interconnexions optiques IO comprennent chacune un coupleur optique CO et un lien optique LO par entrée de circuit intégré d'entrée des ensembles d'une ligne (en l'espèce $\frac{n2}{2}$ liens optiques par coupleur) ou par sortie de circuit intégré de sortie des ensembles d'une colonne en l'espèce $\frac{n1}{2}$ liens optiques par coupleur).

On entend par coupleur optique, un dispositif optique passif comprenant un ou plusieurs ports d'entrée optiques et un ou plusieurs ports de sortie optiques, distribuant chacun des signaux d'entrée sur l'ensemble des ports de sortie.

En variante, on peut utiliser à l'émission, un dispositif de couplage optoélectronique actif comprenant un port d'entrée électrique et plusieurs émetteurs optiques, chacun étant connecté à un port de sortie optique, et distribuant le signal d'entrée électrique sur l'ensemble des ports de sortie optiques.

En variante, on peut utiliser à la réception, un dispositif de couplage optoélectronique actif, comprenant plusieurs ports d'entrée optiques chacun étant connecté à un détecteur optique et un port de sortie électrique, et collectant les signaux d'entrée optiques vers le port de sortie électrique.

Sur l'ensemble des exemples, les liens optiques LO peuvent comprendre de la fibre optique.

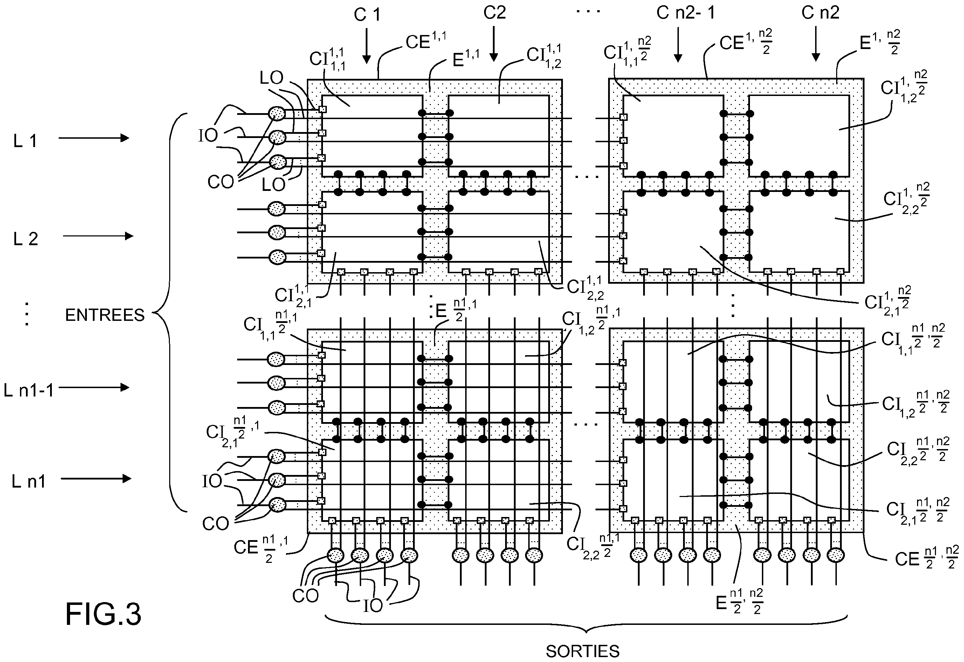

La figure 3 représente un système semblable à celui de la figure 2, dans lequel un ensemble $E^{a,b}$ d'au moins un circuit intégré $CI_{i,j}^{a,b}$ est compris dans une unique carte électronique $CE^{a,b}$. Ainsi, les cartes peuvent être produites en série à l'identique, et être ensuite connectées aisément selon une architecture matricielle, par exemple uniquement par des interconnexion optique IO. Bien entendu, en variante, seule une fraction de ces interconnexions peut être réalisé par des interconnexions optiques.

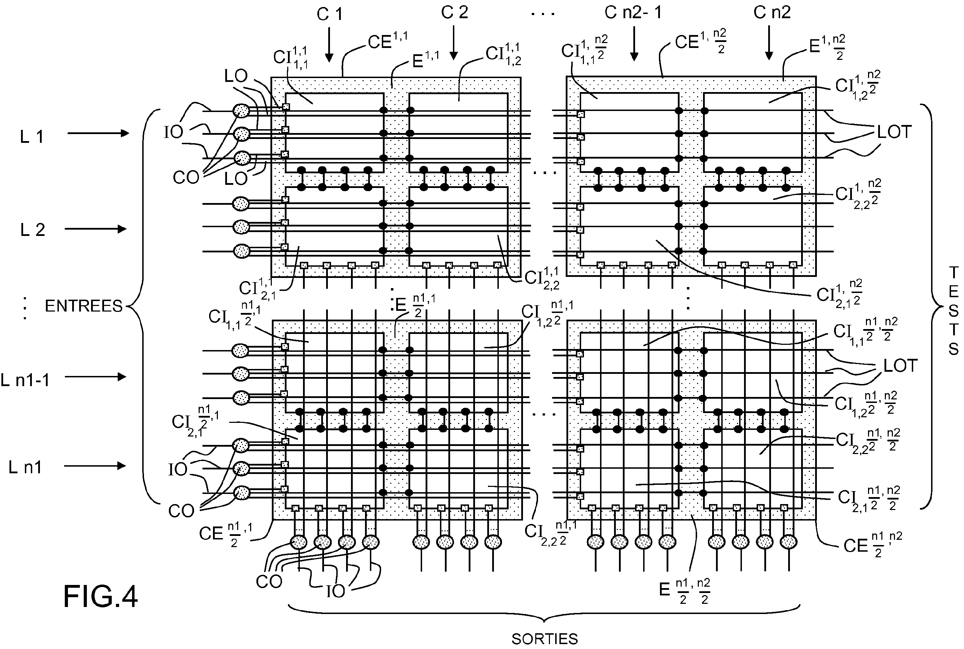

La figure 4 représente un système semblable à celui de la figure 3, dans lequel les interconnexions optiques IO de ligne comprennent, en outre, un lien optique de test LOT, en l'occurrence pour pouvoir observer les données sources. Bien entendu, en variante, seule une fraction de ces interconnexions optiques IO de ligne peuvent être munies d'un lien optique de test LOT. La présence d'un tel lien de test permet de pouvoir effectuer des mesures de manière non intrusive sur cette ligne, ce qui n'est pas le cas sur des interconnexions électriques haut débit qui sont perturbées par l'instrumentation. En variante, les interconnexions optiques IO de ligne peuvent être munies d'une entrée optique supplémentaire de test, en l'occurrence pour pouvoir injecter des données de test. La présence d'un tel lien de test permet de pouvoir effectuer des tests partiels alors que le système est déjà assemblé.

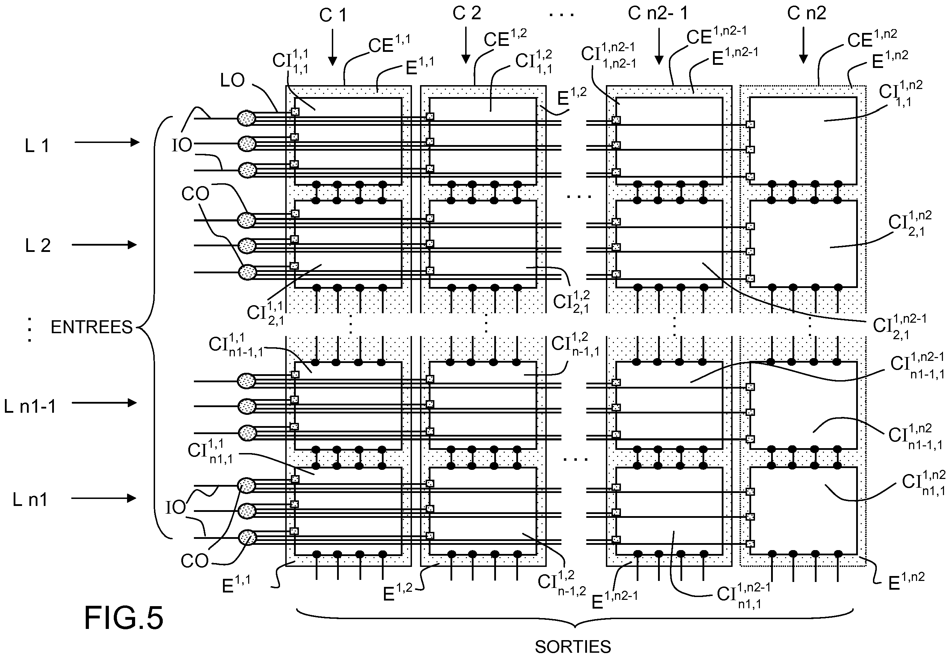

La figure 5 représente un système similaire à celui de la figure 3, dans lequel les interconnexions optiques sont uniquement selon les lignes de l'architecture matricielle, et les cartes électroniques comprennent chacune un ensemble de n1 circuits intégrés disposés en colonne. Cette configuration permet de limiter les interconnexions électriques aux seules interconnexions internes aux cartes électroniques, et de réaliser toutes les interconnexions entre cartes par voie optique.

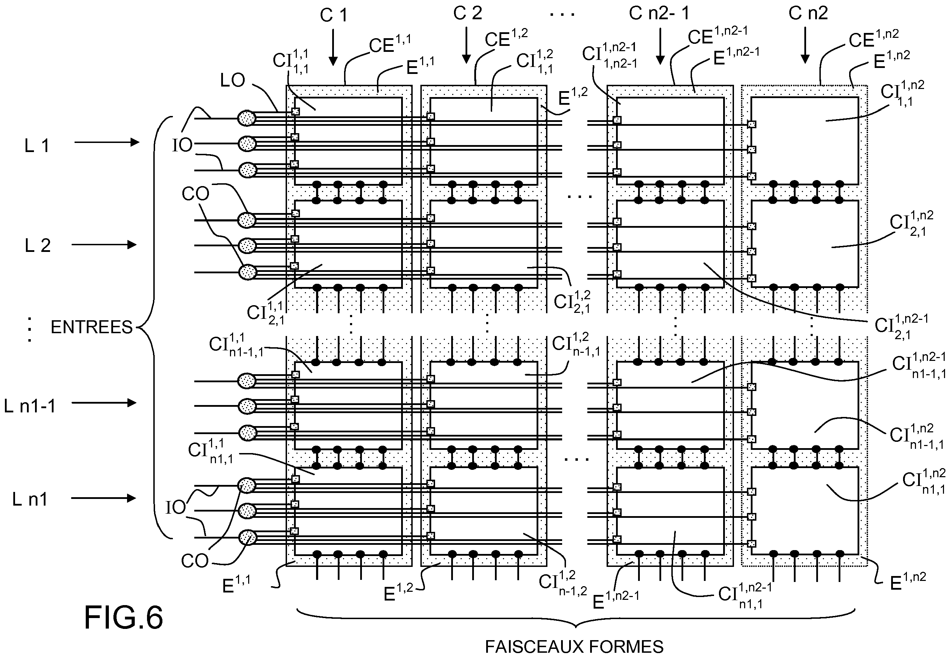

La figure 6 représente un système similaire à celui de la figure 5, pour un processeur de formation de faisceaux pour satellite, dans lequel les interconnexions optiques sont uniquement selon les lignes de l'architecture matricielle. Chaque colonne de circuits intégrés produit un ensemble de sorties de faisceaux à partir de 3xn1 entrées d'une antenne réseau, par exemple en réception. Cette architecture modulaire permet d'augmenter simplement le nombre de faisceaux en ajoutant des cartes électroniques traitant les mêmes entrées.

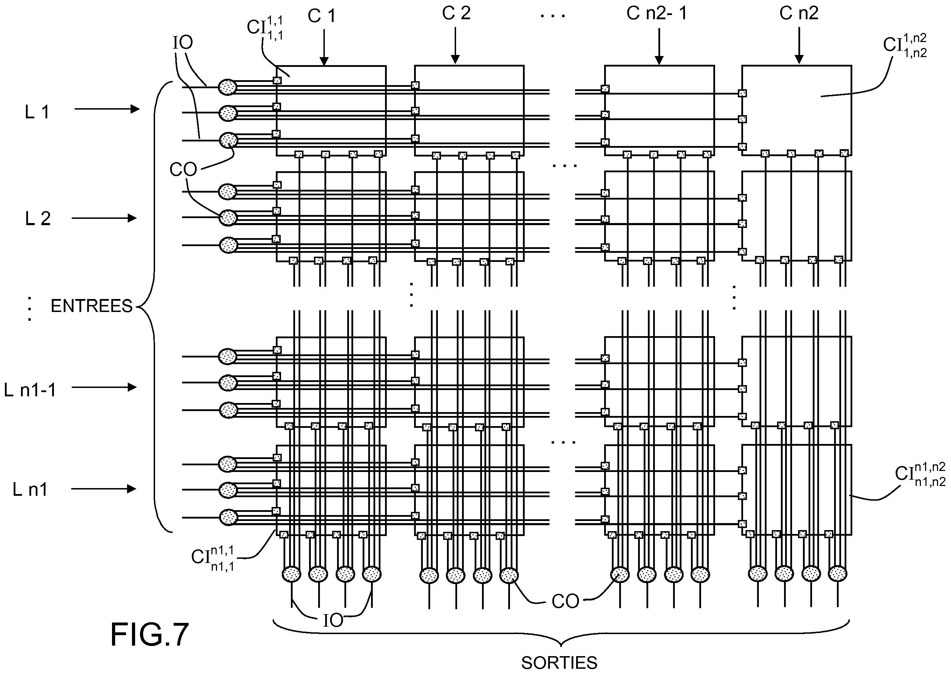

La figure 7 représente un système à architecture matricielle dans lequel l'ensemble des interconnexions pour tous les circuits intégrés, en lignes et colonnes, sont optiques, considérant que chaque ensemble de circuits intégrés comprend un seul circuit intégré. Ce cas de figure correspond à la généralisation de l'utilisation d'interfaces optiques entre circuits intégrés afin de bénéficier de la capacité de diffusion et de recombinaison directe des signaux optiques. Le système peut, par exemple, être réalisé sur une seule carte.

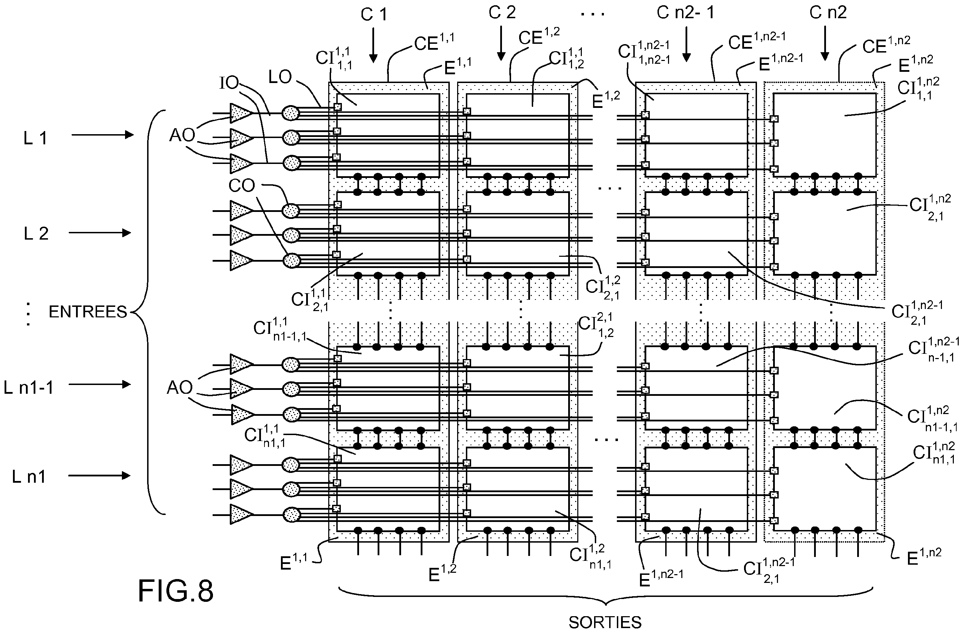

La figure 8 représente un système à architecture matricielle similaire à celui de la figure 5, dans lequel les interconnexions optiques sont uniquement selon les lignes de l'architecture matricielle, les cartes électroniques comprennent chacune un ensemble de n1 circuits intégrés disposés en colonne, et des amplificateurs optiques AO pour compenser l'atténuation des signaux optiques dans les coupleurs optiques.

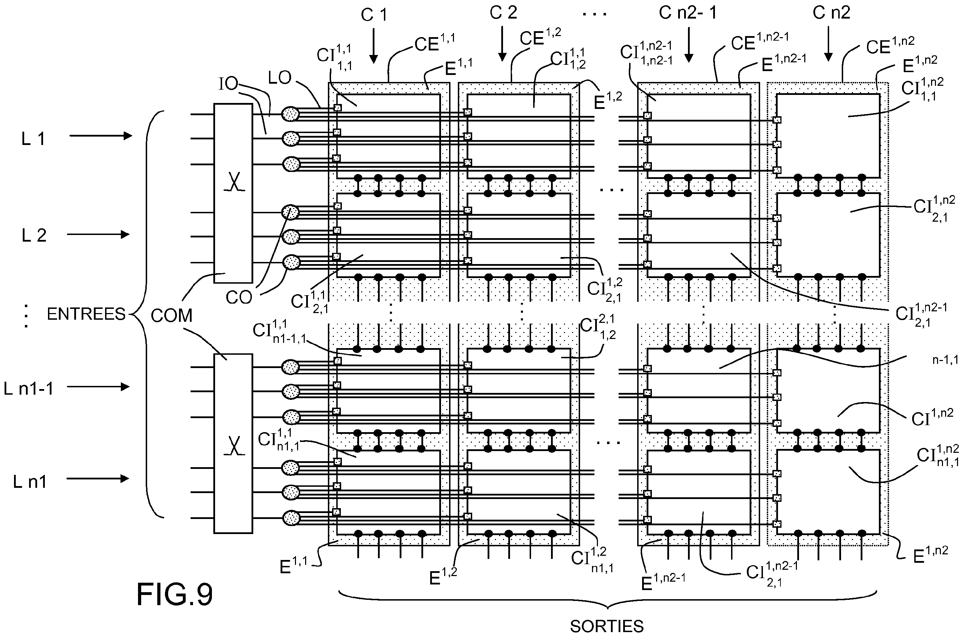

La figure 9 représente un système à architecture matricielle similaire à ceux des figures 5 et 8, comprenant des commutateurs optiques en entrée, permettant de sélectionner, pour des besoins de reconfiguration, les entrées sources à utiliser.

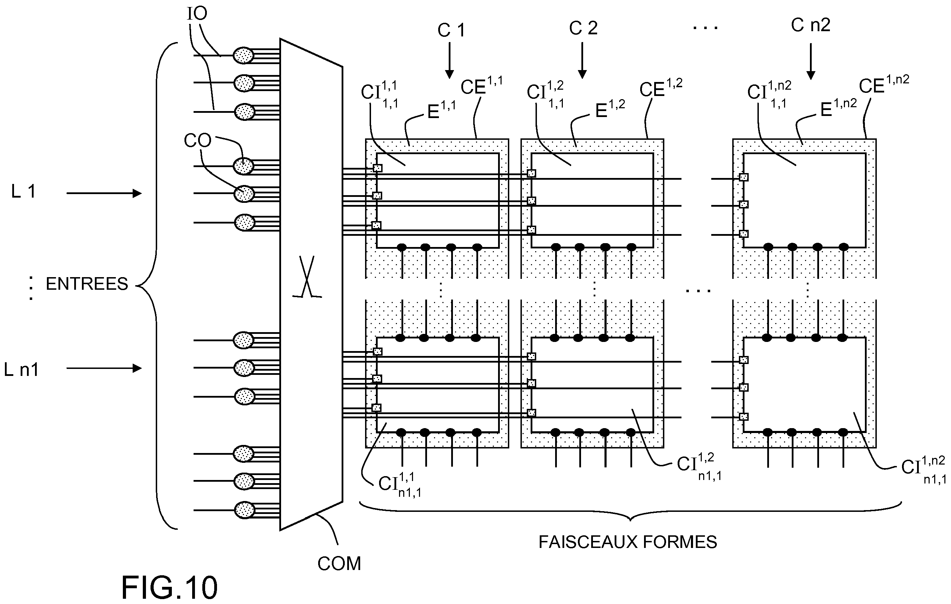

La figure 10 représente un système à architecture matricielle comprenant un commutateur optique COM en entrée pour un processeur de formation de faisceaux pour satellite. En l'occurrence, le commutateur permet de configurer l'association des ensembles de données sources ,issues d'éléments rayonnants en réception ou de faisceaux en émission, aux ensembles de formateurs de faisceaux.

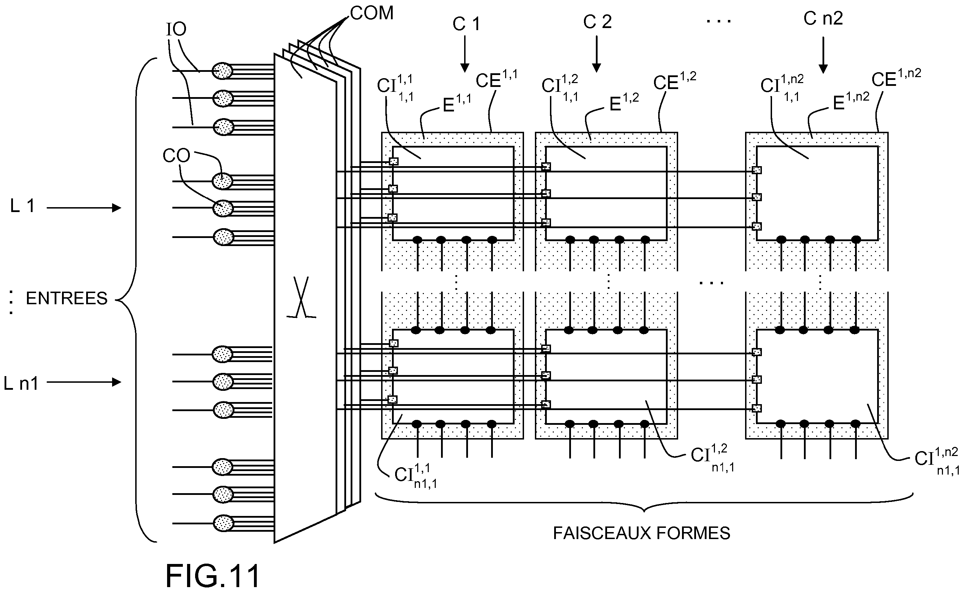

La figure 11 représente un système à architecture matricielle comprenant une pluralité de commutateurs optiques COM en parallèle pour un processeur de formation de faisceaux pour satellite. Moyennant certaines limitations sur les configurations de commutation des liens optiques, la mise en parallèle d'un ensemble de commutateurs optique permet de réduire significativement la complexité de chaque commutateur.

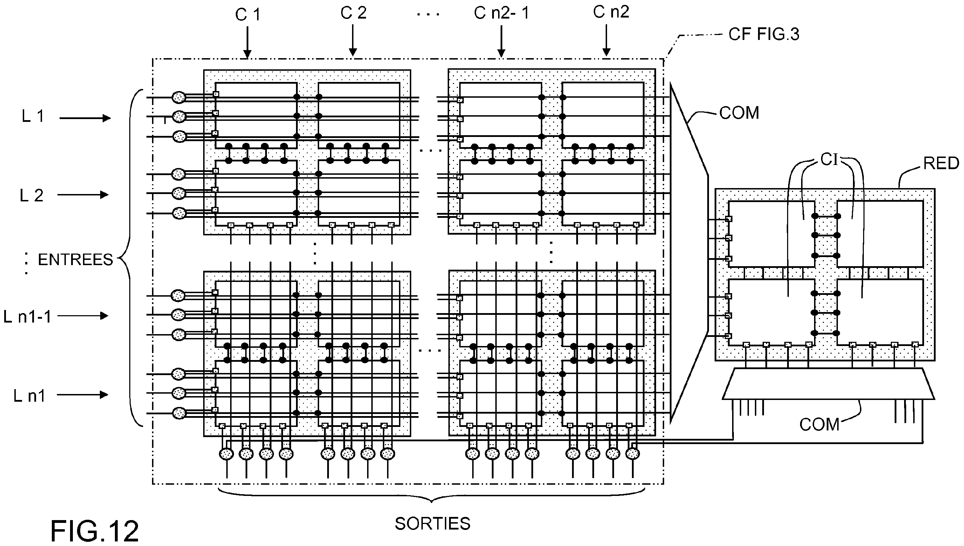

La figure 12 représente un système à architecture matricielle similaire à celui de la figure 4, comprenant des commutateurs optiques COM entre cartes électroniques pour gérer des redondances au niveau des cartes électroniques $CE^{a,b}$. Ce système permet de substituer une carte non utilisée du groupe de redondance RED à toute carte électronique présentant une défaillance.

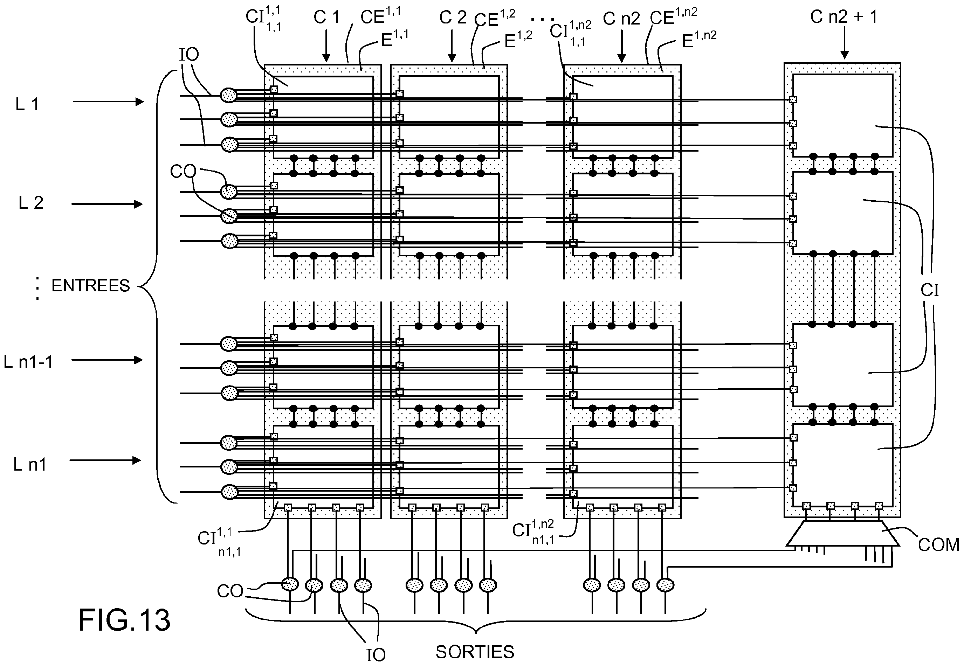

La figure 13 représente un système à architecture matricielle comprenant un commutateur optique COM entre colonnes pour un processeur de formation de faisceaux pour satellite, les cartes électroniques $CE^{a,b}$ comprenant chacune un ensemble de n1 circuits intégrés disposés en colonne. Le système comprend une redondance de r colonnes d'opérateurs et une commutation de ces redondances par colonne (fonction) entière. La défaillance d'un opérateur pénalise l'ensemble de la voie de traitement (verticale) et généralement l'ensemble de la colonne. Ce mode de commutation de redondance consiste à remplacer l'ensemble de la colonne impactée par une colonne redondante disponible. Les r colonnes redondantes, (en l'occurrence r=1 car la seule colonne de redondance est la colonne $C_{n2+1}$) reçoivent les données à traiter par diffusion optique. Les sorties de ces colonnes redondantes sont sélectionnées via un commutateur optique COM (r colonnes de m=4 voies, vers M voies de sortie), dont les M sorties alimentent autant de coupleurs optiques CO en sortie des voies nominales. Ceci mobilise alors un certain nombre d'opérateurs redondants (correspondant au nombre de lignes r×n1 d'opérateurs) pour compenser la défaillance de r opérateurs quelconques.

La distribution optique des signaux se prête à la commutation d'opérateurs redondants, en utilisant la capacité de diffusion à l'aide de coupleurs optiques CO, et par la mise en oeuvre de commutateurs optiques COM. La commutation des redondances peut être réalisée de différentes manières : par colonne entière, par voie de traitement, par circuit ou carte électronique, par ligne, ou par voie de données, les redondances pouvant être mutualisées à différents niveaux.

La figure 13 illustre une commutation des redondances par colonne entière (ou fonction entière)

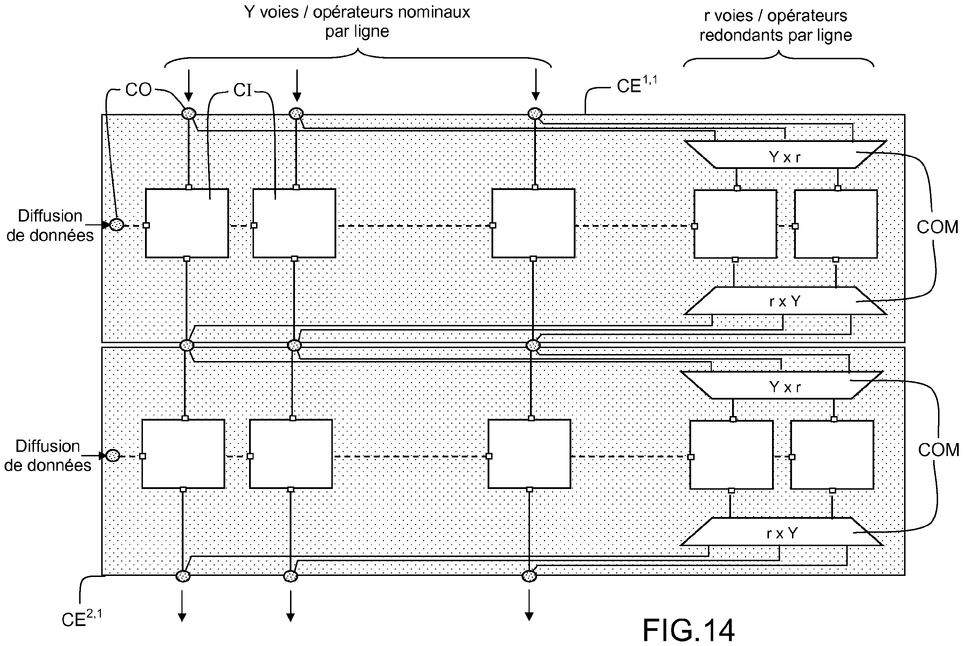

Sur les figures 14 à 18, sont représentés des exemples sur lesquels une ligne est réalisée sur une seule carte électronique.

La figure 14 illustre une commutation des redondances mutualisées séparément par ligne (ou sous-fonction). Un tel mode de réalisation consiste à disposer de r opérateurs redondants au sein de chaque ligne d'opérateurs, avec une commutation de redondance spécifique à chaque ligne. Pour simplifier, la figure 14 présente une seule voie horizontale de diffusion des données par opérateur, ainsi qu'une seule voie verticale de traitement par opérateur. Ce synoptique peut être généralisé avec plusieurs voies de diffusion de données horizontales ainsi que plusieurs voies de traitement verticales par ligne d'opérateurs.

Au sein d'une ligne d'opérateurs, les r opérateurs redondants reçoivent par diffusion optique les données à traiter, comme les Y opérateurs nominaux. Dans cette configuration, les voies de traitement verticales comprennent également des liaisons optiques.

Des coupleurs optiques CO à deux entrées et deux sorties sont associés aux opérateurs nominaux pour diffuser les termes partiels traités et issus de la ligne en amont soit de l'opérateur nominal (de la même colonne), soit d'un opérateur redondant, à destination de l'opérateur nominal et du groupe de redondance associé à la ligne. Pour chaque ligne, le groupe de redondance est commuté à l'aide de deux commutateurs optiques COM, pour commuter les voies de traitement en entrée et en sortie. Ces commutateurs optiques réalisent la commutation entre l'ensemble des voies de traitement des opérateurs nominaux et l'ensemble des voies de traitement des opérateurs redondants.

Cette configuration permet de substituer un opérateur redondant disponible à tout opérateur nominal défaillant, et ce au sein de chaque ligne. L'utilisation des redondance est plus efficace que dans le cas de la commutation de redondance par colonne (ou fonction) entière.

La capacité de redondance par ligne est débordée lorsqu'au moins r+1 opérateurs défaillants sont concentrés sur une même ligne. Ce système peut donc tolérer jusqu'à rxn1 défaillances d'opérateurs.

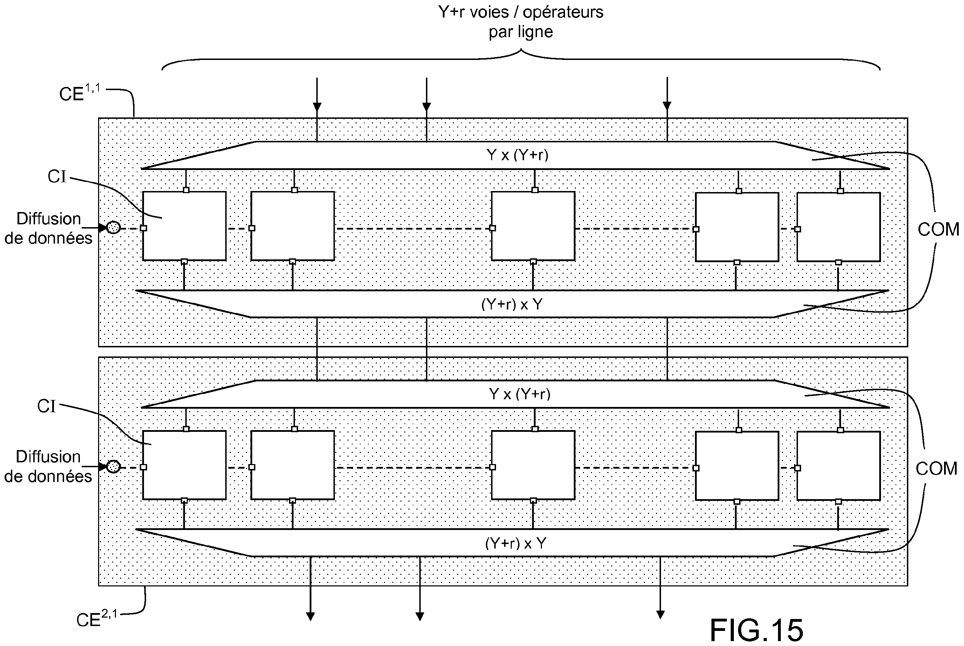

La figure 15 illustre une variante de la figure 14, de commutation des redondances mutualisées séparément par ligne (ou sous-fonction) consistant en une architecture homogène d'opérateurs non différenciés.

Cette variante est plus régulière que le système de la figure 14, sans nécessiter de coupleurs optiques sur les voies de traitement (verticales). En revanche, la complexité des commutateurs optiques COM est accrue, tout en restant très acceptable du fait d'une meilleure symétrie des nombres de ports d'entrée et de sortie (r étant plus faible que Y).

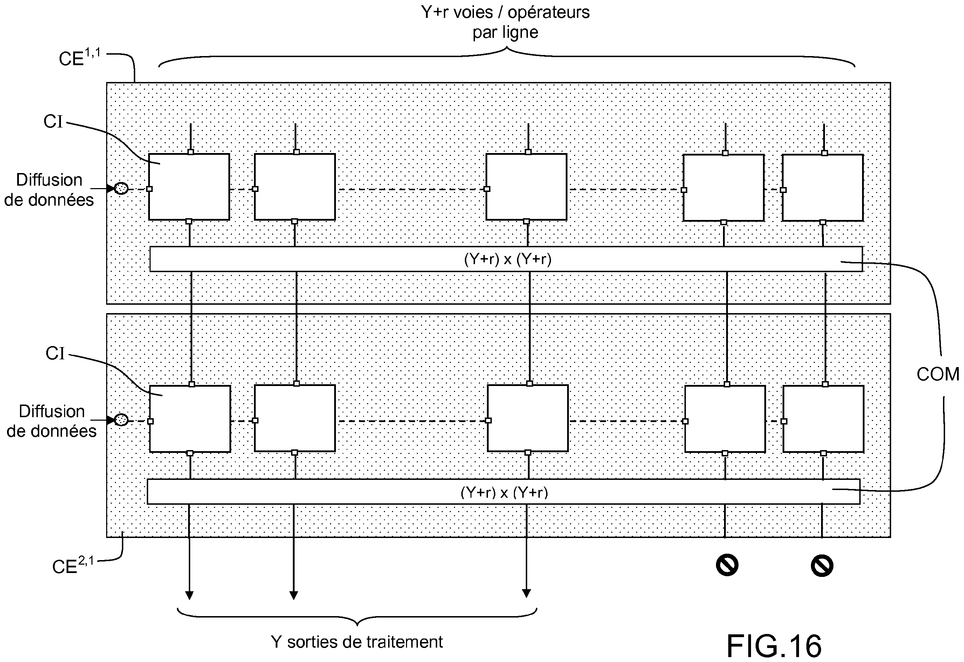

La figure 16 illustre une autre variante des figures 14 et 15 de commutation des redondances mutualisées séparément par ligne (ou sous-fonction). Le système de la figure 15 peut être modifié pour supprimer un des deux commutateurs optiques COM par ligne d'opérateurs. Cette variante consiste à propager Y+r voies de traitements tout le long de la chaîne verticale de traitement, avec un commutateur optique COM à chaque ligne pour définir la connectivité avec les opérateurs de la ligne suivante.

En sortie de la dernière ligne d'opérateurs, on ne conserve que Y sorties physiques. Avec moitié moins de commutateurs COM, cette variante est plus simple que la précédente, la propagation de Y+r voies au lieu de Y voies (utiles) n'étant pas pénalisante (r << Y). En revanche, la complexité des commutateurs optiques COM est légèrement accrue, sans poser de difficultés en pratique, du fait de la symétrie des nombres de ports d'entrée et de sortie et car Y+r est peu différent de Y.

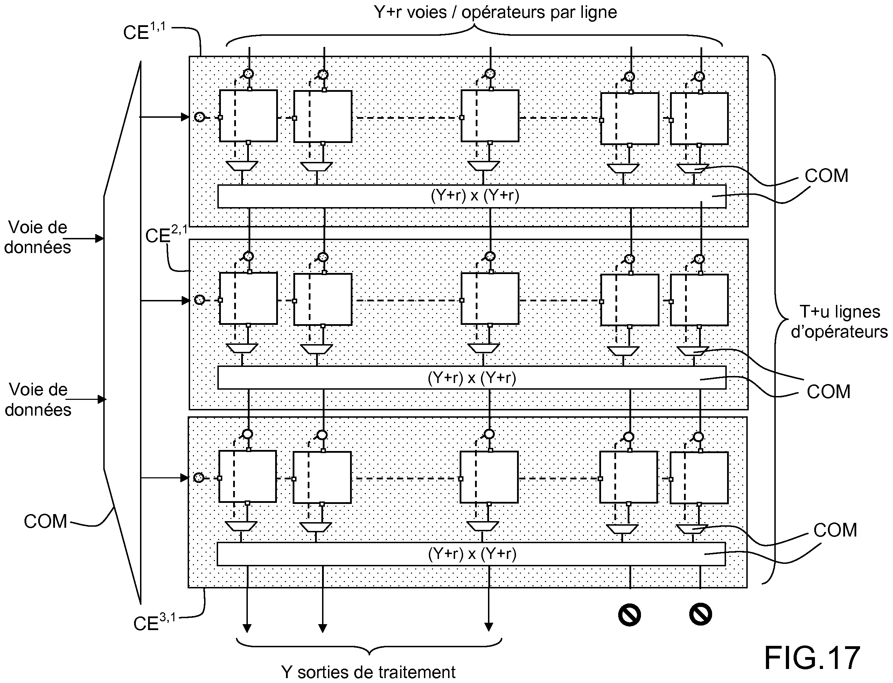

La figure 17 illustre une variante des systèmes des figures 14, 15 et 16, de commutation des redondances mutualisées séparément par ligne (ou sous-fonction). Afin d'améliorer la tolérance aux défaillances des opérateurs, cette variante consiste à provisionner des lignes de redondance en complément des T lignes d'opérateurs nominales qui intègrent déjà chacune r opérateurs redondants.

Partant de la troisième variante, on augmente la capacité de redondance en ajoutant u lignes redondantes aux T lignes d'opérateurs. Ceci permet de remplacer jusqu'à u lignes d'opérateurs dont la capacité de redondance a été débordée (i.e. plus de r opérateurs défaillants).

Un commutateur optique COM en entrée côté données réalise la commutation des T lignes d'entrées vers l'ensemble des T+u lignes d'opérateurs. Une ligne d'opérateur peut être non utilisé, soit lorsqu'il s'agit d'une redondance inactive, soit lorsque la capacité de redondance de cette ligne est débordée par un excès de défaillances. Dans ce cas, les flots (verticaux) de termes partiels issus des lignes en amont doivent traverser de manière transparente la ligne inactive. Une solution consiste à diffuser localement chaque flot de terme partiel amont via un coupleur à une entrée et deux sorties diffusant vers chaque opérateur ainsi que vers une voie dite de contournement pour "bypass" en langue anglaise. Un commutateur COM à deux entrées et une sortie en aval de l'opérateur permet de sélectionner soit la sortie de traitement de l'opérateur, soit la voie de bypass, en entrée du commutateur de sortie Y+r :Y+r .

Cette solution offre une meilleure efficacité d'utilisation des redondances que les variante gérant la redondance par ligne, au prix d'une complexité accrue. En effet, outre la capacité à supporter jusqu'à r défaillances quelconques par ligne, l'ajout de u lignes redondantes permet en plus de supporter jusqu'à u lignes avec plus de r défaillances.

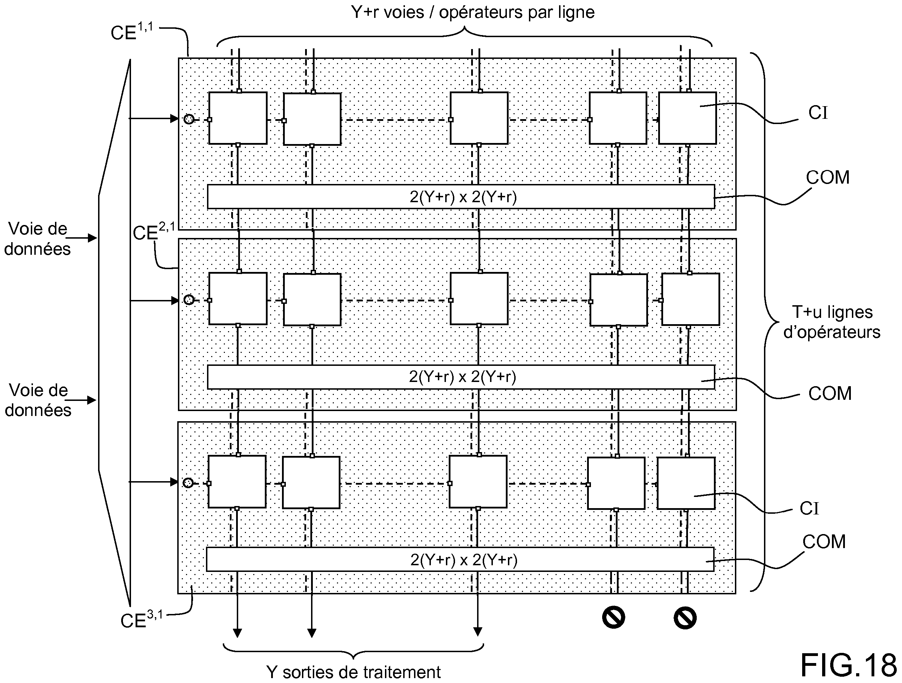

La figure 18 illustre une variante des systèmes des figures 14, 15, 16, et 17 de commutation des redondances mutualisées séparément par ligne (ou sous-fonction). Selon cette variante, les coupleurs optiques à une entrée et deux sorties et les petits commutateurs optiques COM à deux entrées et une sortie sont remplacés par une extension de la capacité du commutateur de sortie, pour commuter Y+r voies bypass en plus, soit une capacité de 2(Y+r) : 2(Y+r). Cette solution permet la même efficacité d'utilisation des redondances que la variante précédente, mais présente une architecture plus simple, avec des communications optiques de plus grande capacité.

Les interfaces optiques des figures 14, 15, 16, 17 et 18 peuvent transporter soit un flux de données associé à un transceiver ou élément d'interface série rapide ("High Speed Serial Link transceiver" en langue anglaise), soit avantageusement un multiplexage de flots de données issus d'un ensemble de transceivers série rapide localisés dans un même opérateur (circuit intégré / module hybride / carte numérique / équipement).

Une variante connue pour multiplexer des flots de données sur voie optique est le multiplexage par répartition en longueur d'onde ou WDM (pour "Wavelength Division Multiplexing" en langue anglaise), chaque flot de donnée étant porté par une longueur d'onde spécifique.

L'utilisation du multiplexage en longueur d'onde WDM sur les schémas proposés est particulièrement efficace car elle permet de réduire directement la densité d'interconnections optiques, et par voie de conséquence la complexité des commutateurs optiques COM. Le multiplexage concerne les flots de données distribués selon une même topologie, ce qui est le cas des architectures numériques matricielles telles que définies, tant pour la diffusion des voies de données que pour la distribution des voies de traitement (termes partiels).

**Revendications**

1. Système d'au moins deux ensembles ($E^{a,b}$) comprenant chacun au moins deux circuits intégrés $\left( CI_{i,j}^{a,b} \right)$, les circuits intégrés $\left( CI_{i,j}^{a,b} \right)$ étant interconnectés selon une architecture matricielle de n1 lignes et n2 colonnes de circuits intégrés $\left( CI_{i,j}^{a,b} \right)$, dans lequel :

- une ligne (k) recevant au moins une entrée de signaux, et une colonne (l) fournissant au moins une sortie de signaux, les interconnexions entre deux circuits intégrés d'une ligne (k) d'un même ensemble et les interconnexions entre deux circuits intégrés d'une colonne (l) d'un même ensemble ($E^{a,b}$) étant électriques,
- chaque ensemble ($E^{a,b}$)comprend au moins un desdits circuits intégrés, dit d'entrée, comprenant au moins une entrée optique et au moins un desdits circuit intégré, dit de sortie, comprenant au moins une sortie dudit ensemble, un circuit intégré d'entrée pouvant éventuellement être un circuit intégré de sortie,

le système comprenant au moins une interconnexion optique (IO) pour connecter une entrée d'une ligne à des entrées de circuits intégrés d'entrée des ensembles de ladite ligne (k), ou pour connecter des sorties de circuits intégrés de sortie des ensembles d'une colonne (l) à une sortie de ladite colonne (l) ; une interconnexion optique (IO) comprenant un coupleur optique (CO) et/ou des moyens de couplage optoélectroniques actifs et un lien optique (LO) par entrée de circuit intégré d'entrée des ensembles d'une ligne (k) ou par sortie de circuit intégré de sortie des ensembles d'une colonne (l).

2. Système selon la revendication 1, dans lequel un ensemble ($E^{a,b}$) est implanté dans une unique carte électronique ($CE^{a,b}$).

3. Système selon l'une des revendications précédentes, dans lequel au moins une interconnexion optique (IO) de ligne (k) comprend, en outre, un lien optique de test (LOT).

4. Système selon l'une des revendications précédentes, dans lequel un lien optique (LO) comprend de la fibre optique.

5. Système selon l'une des revendications précédentes, dans lequel, au moins une interconnexion optique (IO) de ligne (k) comprend, en outre, un amplificateur optique (AO).

6. Système selon l'une des revendications précédentes, dans lequel, plusieurs interconnexions optiques (IO) de ligne (k) sont reliées en entrée par au moins un commutateur optique (COM), et/ou plusieurs interconnexions optiques (IO) de colonne (l) sont reliées en sortie par au moins un commutateur optique (COM).

7. Système selon l'une des revendications précédentes, dans lequel au moins un lien optique (LO) est adapté pour réaliser un multiplexage par répartition en longueur d'onde.

8. Système selon l'une des revendications précédentes, comprenant au moins un ensemble de circuits intégrés en redondance, munis de liens optiques (LO).

9. Système selon l'une des revendications précédentes, adapté pour réaliser une fonction de formation numérique de faisceaux d'antenne.

10. Système selon l'une des revendications précédentes, adapté pour réaliser une fonction de commutation.

11. Processeur comprenant au moins un système selon l'une des revendications précédentes.

12. Satellite comprenant au moins un processeur selon la revendication 11, embarqué à bord.

**Patentansprüche**

1. System, bestehend aus mindestens zwei Anordnungen ($E^{a,b}$), welche jeweils mindestens zwei integrierte Schaltkreise $\left( CI_{i,j}^{a,b} \right)$ beinhalten, wobei die integrierten Schaltkreise $\left( CI_{i,j}^{a,b} \right)$ entsprechend einer Matrixarchitektur von n1 Zeilen und n2 Spalten von integrierten Schaltkreisen $\left( CI_{i,j}^{a,b} \right)$ miteinander verbunden sind, bei welchem:

- eine Zeile (k) mindestens einen Signaleingang empfängt, und eine Spalte (l) mindestens einen Signalausgang bereitstellt, wobei die Verbindungen zwischen zwei integrierten Schaltkreisen einer Zeile (k) einer gleichen Anordnung und die Verbindungen zwischen zwei integrierten Schaltkreisen einer Spalte (l) einer gleichen Anordnung ($E^{a,b}$) elektrisch sind,
- wobei jede Anordnung ($E^{a,b}$) mindestens einen der integrierten Schaltkreise, genannt Eingangs schaltkreis, beinhaltet, welcher mindestens einen optischen Eingang beinhaltet, und mindestens einen der integrierten Schaltkreise beinhaltet, genannt Ausgangsschaltkreis, welcher mindestens einen Ausgang der Anordnung beinhaltet, wobei ein integrierter Eingangs schaltkreis eventuell ein integrierter Ausgangsschaltkreis sein kann, wobei das System mindestens eine optische Verbindung (IO) zum Verbinden eines Eingangs einer Zeile mit Eingängen integrierter Eingangsschaltkreise der Anordnungen der Zeile (k) oder zum Verbinden von Ausgängen integrierter Ausgangsschaltkreise der Anordnungen einer Spalte (l) mit einem Ausgang der Spalte (l) beinhaltet; wobei eine optische Verbindung (IO) einen Optokoppler (CO) und/oder aktive optoelektronische Kopplungsmittel und einen optischen Link (LO) pro Eingang eines integrierten Eingangsschaltkreises der Anordnungen einer Zeile (k) oder pro Ausgang eines integrierten Ausgangsschaltkreises der Anordnungen einer Spalte (l) beinhaltet.

2. System nach Anspruch 1, bei welchem eine Anordnung ($E^{a,b}$) in einer einzigen elektronischen Karte ($CE^{a,b}$) angeordnet ist.

3. System nach einem der vorhergehenden Ansprüche, bei welchem mindestens eine optische Verbindung (IO) einer Zeile (k) zudem einen optischen Testlink (LOT) beinhaltet.

4. System nach einem der vorhergehenden Ansprüche, bei welchem ein optischer Link (LO) Lichtwellenleiter beinhaltet.

5. System nach einem der vorhergehenden Ansprüche, bei welchem mindestens eine optische Verbindung (IO) einer Zeile (k) zudem einen optischen Verstärker (AO) beinhaltet.

6. System nach einem der vorhergehenden Ansprüche, bei welchem mehrere optische Verbindungen (IO) einer Zeile (k) am Eingang durch mindestens einen optischen Umschalter (COM) verbunden sind, und/oder mehrere optische Verbindungen (IO) einer Spalte (l) am Ausgang durch mindestens einen optischen Umschalter (COM) verbunden sind.

7. System nach einem der vorhergehenden Ansprüche, bei welchem mindestens ein optischer Link (LO) geeignet ist, um ein Multiplexing durch Wellenlängenverteilung auszuführen.

8. System nach einem der vorhergehenden Ansprüche, welches mindestens eine redundante Anordnung von integrierten Schaltkreisen beinhaltet, welche mit optischen Links (LO) versehen sind.

9. System nach einem der vorhergehenden Ansprüche, welches geeignet ist, eine digitale Antennenstrahlformungsfunktion auszuführen.

10. System nach einem der vorhergehenden Ansprüche, welches geeignet ist, eine Umschaltfunktion auszuführen.

11. Prozessor, welcher mindestens ein System nach einem der vorhergehenden Ansprüche beinhaltet.

12. Satellit, welcher mindestens einen an Bord mitgeführten Prozessor nach Anspruch 11 beinhaltet.

**Claims**

1. System of at least two assemblies ($E^{a,b}$) each comprising at least two integrated circuits $\left( CI_{i,j}^{a,b} \right)$, the integrated circuits $\left( CI_{i,j}^{a,b} \right)$ being interconnected according to a matrix architecture of n1 rows and n2 columns of integrated circuits $\left( CI_{i,j}^{a,b} \right)$, wherein:

- a row (k) receiving at least one input of signals, and a column (l) providing at least one output of signals, the interconnections between two integrated circuits of a row (k) of one and the same assembly and the interconnections between two integrated circuits of a column (l) of one and the same assembly ($E^{a,b}$) being electrical,
- assembly ($E^{a,b}$) comprises at least one of said integrated circuits, called input integrated circuit, comprising at least one optical input and at least one of said integrated circuits, called output integrated circuit, comprising at least one output of the said assembly, an input integrated circuit being able optionally to be an output integrated circuit, the system comprising at least one optical interconnection (IO) for connecting an input of a row to inputs of input integrated circuits of the assemblies of said row (k), or for connecting outputs of the output integrated circuits of the assemblies of a column (l) to an output of the said column (l); an optical interconnection (IO) comprising an optical coupler (CO) and/or active optoelectronic coupling means and an optical link (LO) per input of input integrated circuit of the assemblies of a row (k) or per output of output integrated circuit of the assemblies of a column (l).

2. System according to claim 1, in which an assembly ($E^{a,b}$) is implanted in a single electronic card ($CE^{a,b}$).

3. System according to one of the preceding claims, in which at least one row (k) optical interconnection (IO) comprises, furthermore, a test optical link (LOT).

4. System according to one of the preceding claims, in which an optical link (LO) comprises optical fibre.

5. System according to one of the preceding claims, in which at least one row (k) optical interconnection (IO) comprises, furthermore, an optical amplifier (AO).

6. System according to one of the preceding claims, in which several row (k) optical interconnections (IO) are linked at input by at least one optical switch (COM), and/or several column (l) optical interconnections (IO) are linked at output by at least one optical switch (COM).

7. System according to one of the preceding claims, in which at least one optical link (LO) is adapted for carrying out a wavelength division multiplexing.

8. System according to one of the preceding claims, comprising at least one assembly of integrated circuits as redundancy, featuring optical links (LO).

9. System according to one of the preceding claims, adapted for carrying out a function of digital antenna beam forming.

10. System according to one of the preceding claims, adapted for carrying out a switching function.

11. Processor comprising at least one system according to one of the preceding claims.

12. Satellite comprising at least one processor according to claim 11 on board.

FIG.1

FIG.2

FIG.3

EP 2 582 048 B1

FIG.4

FIG.5

FIG.6

FIG.7

FIG.8

EP 2 582 048 B1

FIG.9

FIG.10

FIG.11

EP 2 582 048 B1

FIG.12

FIG.13

EP 2 582 048 B1

FIG.14

Y voies / opérateurs nominaux par ligne

r voies / opérateurs redondants par ligne

CO

CI

$CE^{1,1}$

Diffusion de données

$Y \times r$

COM

$r \times Y$

Diffusion de données

$Y \times r$

COM

$r \times Y$

$CE^{2,1}$

EP 2 582 048 B1

FIG.15

Y+r voies / opérateurs par ligne

CE$^{1,1}$

CI

Diffusion de données

Y x (Y+r)

(Y+r) x Y

COM

CI

Diffusion de données

Y x (Y+r)

(Y+r) x Y

COM

CE$^{2,1}$

EP 2 582 048 B1

Y+r voies / opérateurs par ligne

$CE^{1,1}$

CI

Diffusion de données

$(Y+r) \times (Y+r)$

CI

Diffusion de données

$(Y+r) \times (Y+r)$

$CE^{2,1}$

COM

Y sorties de traitement

FIG.16

Y+r voies / opérateurs par ligne

CE$^{1,1}$

Voie de données

CE$^{2,1}$

Voie de données

COM

CE$^{3,1}$

$(Y+r) \times (Y+r)$

COM

$(Y+r) \times (Y+r)$

COM

$(Y+r) \times (Y+r)$

COM

COM

T+u lignes d'opérateurs

Y sorties de traitement

FIG.17

EP 2 582 048 B1

CE^{1,1}

Y+r voies / opérateurs par ligne

CI

2(Y+r) x 2(Y+r)

COM

Voie de données

CE^{2,1}

T+u lignes d'opérateurs

2(Y+r) x 2(Y+r)

COM

Voie de données

CI

2(Y+r) x 2(Y+r)

COM

CE^{3,1}

Y sorties de traitement

FIG.18

EP 2 582 048 B1

## RÉFÉRENCES CITÉES DANS LA DESCRIPTION

**Documents brevets cités dans la description**

- US 20050256969 A1
- US 4811210 A
- US 4696059 A